# EUROPEAN PATENT SPECIFICATION

(11) **EP 3 383 146 B1**
(45) Date of publication and mention of the grant of the patent: **26.07.2023**
(21) Application number: 18162667.2
(22) Date of filing: 19.03.2018
(51) Int. Cl.: H05K 1/02, H05K 3/28, H05K 1/18

(54) **LIGHTING DEVICE WITH IP PROTECTION AND MULTIDIRECTIONAL BENDING CAPABILITY, AND METHOD FOR MANUFACTURING THE SAME**
BELEUCHTUNGSVORRICHTUNG MIT IP-SCHUTZ UND MULTIDIREKTIONALER BIEGEFÄHIGKEIT UND VERFAHREN ZUR HERSTELLUNG DAVON
DISPOSITIF D'ÉCLAIRAGE À PROTECTION IP ET CAPACITÉ DE FLEXION MULTIDIRECTIONNEL ET SON PROCÉDÉ DE FABRICATION

(30) Priority: 31.03.2017 IT 201700035744
(43) Date of publication of application: 03.10.2018
(73) Proprietor: OPTOTRONIC GmbH, 85748 Garching (DE)
(72) Inventor: VOLPATO, Mr. Luca, I-31022 Preganziol (Treviso) (IT); GRIFFONI, Alessio, I-30030 Fossò (Venezia) (IT); REISS, Mr. Martin, D-93161 Sinzing (DE)
(74) Representative: Marchitelli, Mauro

(56) References cited:
- EP-A1- 2 484 956
- EP-B1- 2 484 956
- WO-A1-2016/178322
- WO-A1-2017/052274
- WO-A2-2011/052885
- US-A1- 2012 044 669
- US-A1- 2012 217 520
- US-A1- 2014 001 498
- US-A1- 2014 211 449
- US-A1- 2015 069 452
- US-A1- 2016 103 534
- US-A1- 2016 105 950

## Description

### Technical Field

The present description relates to lighting devices.

One or more embodiments may refer to lighting modules employing electrically powered solid-state light radiation sources, e.g. LED sources.

One or more embodiments may concern linear, flexible LED lighting modules (also known as LED stripes) having IP protection and being adapted to be bent in any direction.

One or more embodiments may also concern a method for producing said lighting modules.

### Technological Background

In the sector of lighting technology the use is widespread of lighting devices or modules having an elongated, e.g. ribbon-like, shape, and which may include a flexible printed circuit having the shape of a thin elongated ribbon, hosting a plurality of solid-state, e.g. LED, light radiation sources.

The flexible printed circuits of the linear lighting devices may have a plurality of mounting portions for light radiation sources, which are spaced apart in a longitudinal direction and are mutually connected by conductive tracks.

Generally speaking, such linear lighting devices exhibit good flexibility in a plane orthogonal to the plane of the printed circuit. However, in most cases such lighting devices have a limited bending capability in a transverse direction lying in the plane of the flexible printed circuit.

US 2012/0217520 A1 discloses bar on which a plurality of LEDs are mounted. The bar has a first side surface having a plurality of grooves and a second side surface having a plurality of grooves, wherein the grooves formed at the first side surface and the second grooves formed at the second side surface intersect each other such that the bar can be easily bent in a widthwise direction.

The known techniques used for sealing the flexible LED lighting devices further worsen the bending capability of the LED modules, because they further stiffen the lighting device especially as regards transverse flexibility.

A typical solution for providing a certain IP protection to LED stripes may envisage a surface coating with a thick layer of lacquer or transparent polymeric material. The achievable protection degree is typically limited to IP65. Another typical solution may envisage the use of transparent protection tubes or sleeves, which may impart a higher protection degree, up to IP66 or IP67. Both solutions further jeopardize the limited transverse flexibility of LED stripes. As a matter of fact, the surface protection materials are not particularly flexible, while the plastic tubes, having e.g. a rectangular cross section, may be rather stiff to transverse bending in their lying plane. A known example of applying a transparent polymeric material is disclosed in WO2016/178322.

In other instances, the LED stripes may be protected by arranging them within a U-shaped silicone profile and then filling the internal volume of the profile with a silicone potting material, which may be transparent at least in the upper layer in order to maximize light output efficiency. The transverse flexibility in the lying plane of the resulting LED module may be slightly better than the previously described solutions, thanks to the softer material, but it is still unsatisfactory.

### Object and Summary

One or more embodiments aim at helping overcome the previously outlined drawbacks.

More specifically, one or more embodiments aim at providing linear flexible protected lighting devices which are adapted to be easily bent also in their lying plane.

According to one or more embodiments, said objects may be achieved thanks to a lighting device having the features set forth in the claims that follow.

One or more embodiments may also refer to a corresponding method of production.

The claims are an integral part of the technical teaching provided herein with reference to the embodiments.

One or more embodiments may enable the implementation of e.g. flexible (e.g. LED) lighting modules having IP protection and exhibiting improved transverse bending capability in the lying plane.

### Brief Description of the Figures

One or more embodiments will now be described, by way of non-limiting example only, with reference to the annexed Figures, wherein:
- Figures 1 and 2 are plan views of various embodiments of elongated lighting devices,
- Figure 3 is a schematic lateral view showing an apparatus for encapsulating elongated lighting devices,
- Figures 4, 5 and 6 are longitudinal sections showing an embodiment of a method for forming an encapsulation coating,
- Figure 7 is a schematic section taken along line VII-VII of Figure 4,
- Figure 8 is a side view of an encapsulated lighting device,
- Figures 9 and 10 are schematic side sections showing an embodiment of a two-stage encapsulation method,
- Figure 11 is a side view of a lighting device with a bi-component encapsulation, and
- Figure 12 is a plan view of an embodiment of a lighting device provided with through openings in the encapsulation coating.

It will be appreciated that, for clarity and simplicity of illustration, the various Figures may not be drawn to the same scale.

### Detailed Description

In the following description, various specific details are given to provide a thorough understanding of one or more exemplary embodiments. In other instances, well-known structures, materials or operations are not shown or described in detail in order to avoid obscuring various aspects of the embodiments.

The headings provided herein are for convenience only, and therefore do not interpret the extent of protection or scope of the embodiments.

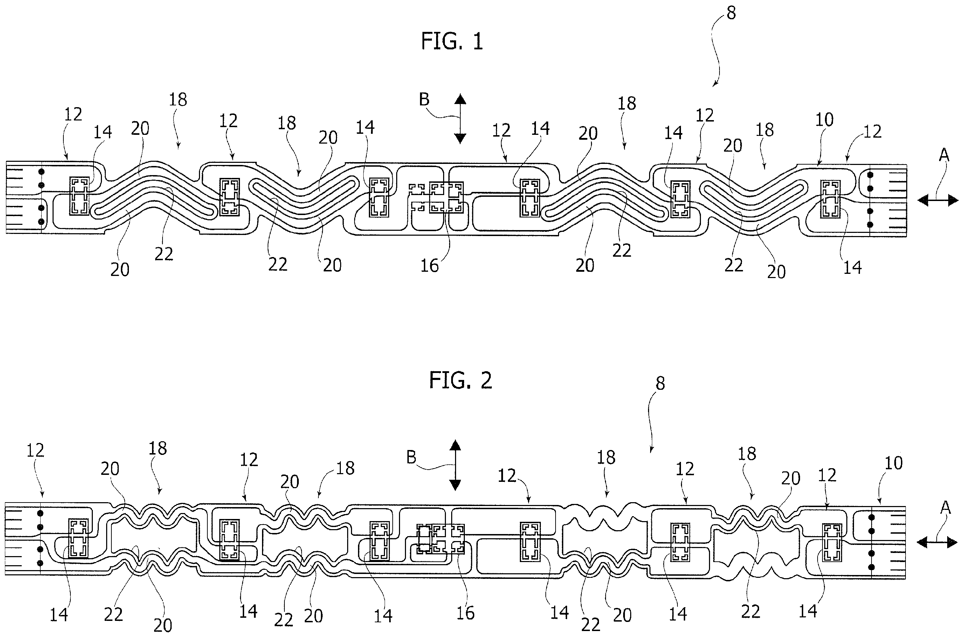

In Figures 1 and 2, reference 8 denotes a bare elongated lighting device. The lighting device 8 includes a flexible printed circuit 10 elongated in a longitudinal direction A. The flexible printed circuit 10 may include an insulating support having the shape of a thin ribbon. The flexible printed circuit 10 has a plurality of mounting portions 12, which are mutually spaced apart in the longitudinal direction A. The mounting portions 12 may have conductive areas, configured to receive electrically powered light radiation sources 14, which may include solid-state light radiation sources, e.g. LED sources. The light radiation sources 14 are fixed to the mounting portions 12 according to known criteria, which do not require a description herein. On one or more of the mounting portions 12 there may be fixed electronic components 16 for driving / controlling the light radiation sources 14.

The mounting portions 12 of the flexible printed circuit 10 are connected to each other by deformation portions 18, which include two conductive tracks 20, which are spaced apart in a transverse direction B. In one or more embodiments, one or more deformation portions 18 have a through opening 22. The through opening 22 separates two conductive tracks 20 from each other in a transverse direction B.

The deformation portions 18 may be configured in order to impart the flexible printed circuit 10 better bending properties in a transverse direction B, contained in the plane of the flexible printed circuit 10. At the deformation portions 18, the conductive track 20 or each conductive track 20 may behave as a sort of linear bridge, adapted to enable a relative deformation movement of the neighbouring mounting portions 12 by flexing or bending in the general lying plane of the flexible printed circuit 10, generally in the transverse direction denoted with arrow B in Figures 1 and 2. The deformation portions 18 may of course also impart flexibility in a plane orthogonal to the lying plane of the flexible printed circuit 10.

The deformation portions 18 may have different shapes, designed to optimize the transverse bending capability. For example, as exemplified in Figure 1, the deformation portions 18 may have conductive tracks having a general shallow V-shape. The V-shaped profiles of the conductive tracks 20 of deformation portions 18 may have concavities alternatively facing opposite directions. For example, as exemplified in Figure 1, a deformation portion 18 may have a concavity facing a first side edge of the flexible printed circuit 10, and the following deformation portion 18 may have a concavity facing the opposite side edge.

In one or more embodiments, as exemplified in Figure 2, the conductive tracks of the deformation portions 18 may have a meander-like shape.

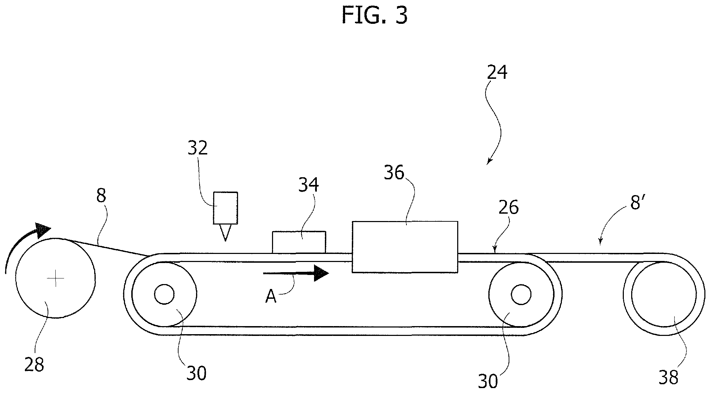

In one or more embodiments, the flexible printed circuit 10 with the light radiation sources 14 and the electronic components 16 fixed on the mounting portions 12 are enclosed in an encapsulation layer. In one or more embodiments, the encapsulation layer is dispensed in liquid form, and subsequently crosslinked by means of a continuous moulding process, which is schematically exemplified in Figure 3.

With reference to Figure 3, reference 24 generally denotes an apparatus for forming an encapsulation layer on a lighting device 8. The apparatus 24 may include a profiled mould 26, adapted to receive therein a portion of the bare elongated lighting device 8. The bare lighting device 8 may have an indefinite length, and may be wound in a reel 28. The profiled mould 26 may be movable in the longitudinal direction A. The profiled mould 26 may include a flexible plastic profile, which forms a closed loop around two pulleys 30, which move the profiled mould 26 in the direction A.

In one or more embodiments, the apparatus 24 may include a dispensing unit 32 adapted to supply, into the profiled mould 26, liquid cross-linkable material, e.g. liquid silicone. In one or more embodiments, the apparatus 24 may include an orientation unit 34, for the correct orientation of the lighting device 8 within mould 26.

In one or more embodiments, the apparatus 24 may include a crosslinking unit 36, in order to crosslink the liquid cross-linkable material within mould 26.

Downstream the crosslinking unit 36, an encapsulated lighting device 8 may be obtained and subsequently extracted from mould 26 and wound in a reel 38.

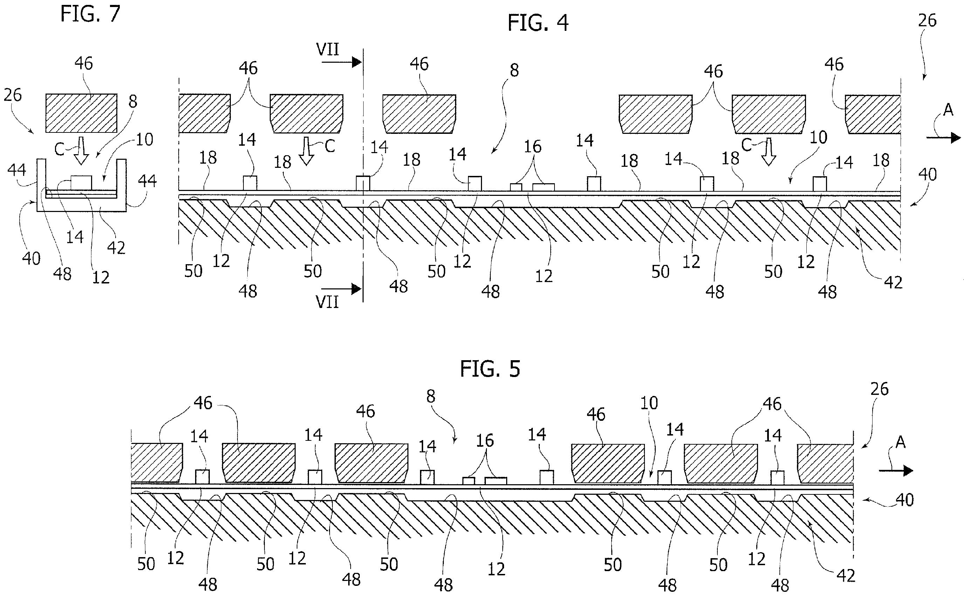

With reference to Figure 7, the profiled mould 26 may include a channel-shaped profile 40, which may have a bottom wall 42 and two side walls 44. The channel-shaped profile 40 may have an open side opposite the bottom wall 42.

With reference to Figures 4 to 7, the profiled mould 26 may include filling formations 46 which may be movable with respect to the channel-section profile 40, between an extracted position and a position inserted in the direction denoted by arrows C in Figure 4. The bottom wall 42 of the channel-shaped profile 40 may have a sequence of lowered portions 48 and of raised portions 50. Filling formations 46 may be positioned at the raised portions of the bottom wall 42. The channel-section profile 40 and the filling formations 46 may be movable integrally with each other in the longitudinal direction A.

With reference to Figure 4, the flexible printed circuit 10 with the light radiation sources 12 and the electronic components 16 fixed thereon may be positioned within the channel-shaped profile 40 when the filling formations 46 are in the extracted position. The flexible printed circuit 10 may be positioned on the bottom wall 42 of the channel-section profile 40. The deformation portions 18 of the flexible printed circuit 10 may be positioned at the raised portions 50 of the bottom wall 42. The mounting portions 12 of the flexible printed circuit 10 on which the light radiation sources 14 are mounted may be positioned at the lowered portions 48 of bottom wall 42.

Subsequently, as shown in Figure 5, the filling portions 46 may be inserted into the channel-section profile 40 of mould 26. The filling portions 46 may be positioned at the deformation portions 18 of the flexible printed circuit 10.

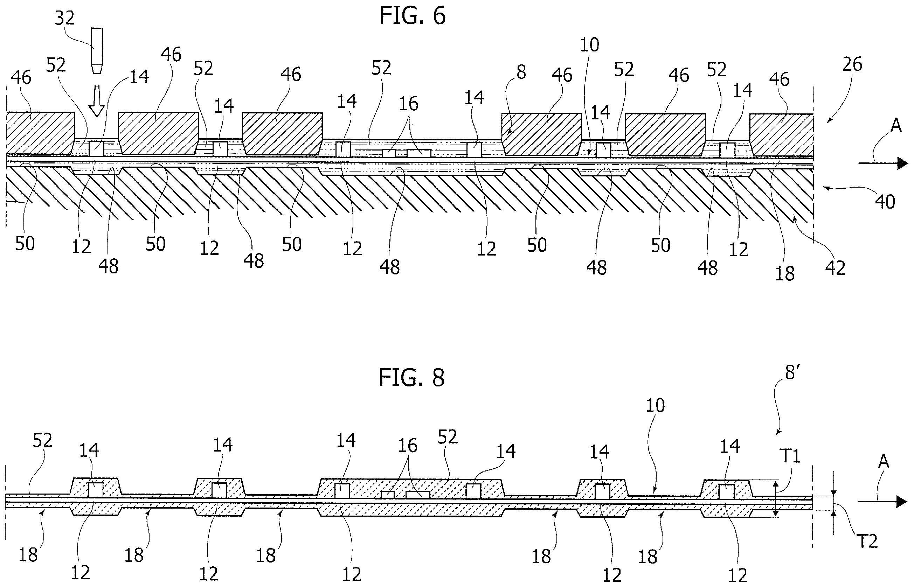

Therefore, as shown in Figure 6, the dispensing unit 32 dispenses, into the channel-section profile 40 of mould 26, liquid cross-linkable material 52. The filling portions 46 limit the thickness of the liquid cross-linkable material 52 at the deformation portions 18 of the flexible printed circuit 10. The liquid cross-linkable material 52 may cover the flexible printed circuit 10, the light radiation sources 14 and the optional electronic components 16.

After dispensing the liquid cross-linkable material 52, the profiled mould 26 may continuously pass through the crosslinking unit 36, wherein the liquid cross-linkable material 52 may be brought to the solid state. After crosslinking, the crosslinked material forms an encapsulation layer 52 of polymeric material. As shown in Figure 8, the encapsulation layer 52 may cover the flexible printed circuit 10, the light radiation sources 14 and the optional electronic components 16.

With reference to Figure 8, in one or more embodiments the encapsulation layer 52 of crosslinked polymeric material may have a first thickness T1 at the mounting portions 12 of the flexible printed circuit 10, and a second thickness T2, smaller than the first thickness T1, at the deformation portions 18. In one or more embodiments, the second thickness T2 is substantially smaller than the first thickness T1. For example, the second thickness T2 may be less than 50% of the first thickness T1.

The particular internal shape of mould 26 when the filling formations 46 are inserted may enable dispensing liquid cross-linkable material 52 having different thicknesses along the longitudinal direction A. When the liquid cross-linkable material 52 has solidified and the filling formations 46 have been removed, an encapsulated lighting device 8' is obtained wherein the encapsulation layer 52 has a variable thickness, which is much thinner at the deformation portions 18. In this way, the transverse bending capability of the lighting device 10 is not hampered by the encapsulation layer 52.

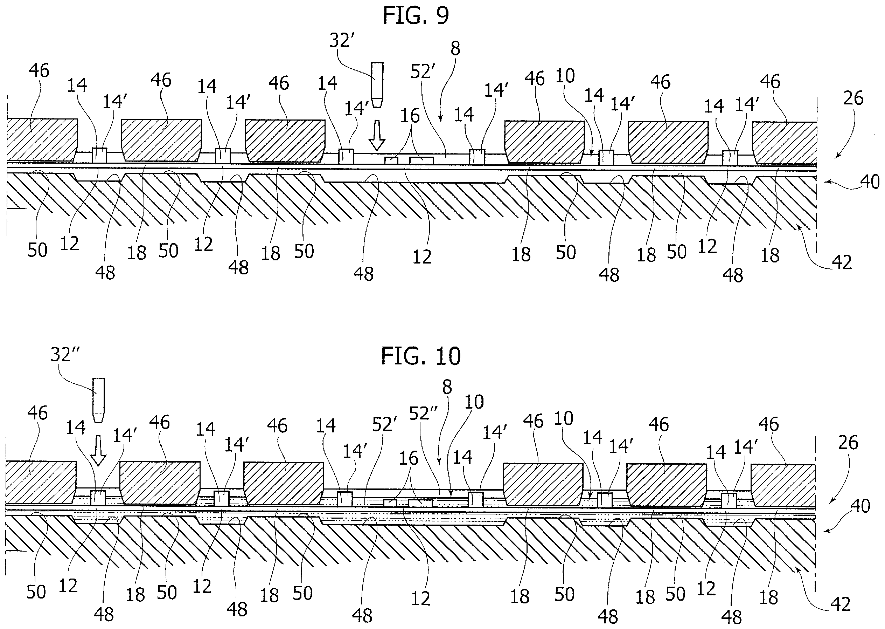

With reference to Figures 9-11, in one or more embodiments the cross-linkable material may be dispensed in two stages. In a first stage, exemplified in Figure 9, a first liquid cross-linkable material 52' may be dispensed by means of a first dispensing unit 32'. The first liquid cross-linkable material 52' may be opaque, e.g. coloured silicone, e.g. white or any other colour. The first liquid cross-linkable material 52' may cover the flexible printed circuit 10, the electronic components 16 and part of the light radiation sources 14, while leaving exposed the light emission ends 14' of the light radiation sources 14 (Figure 9).

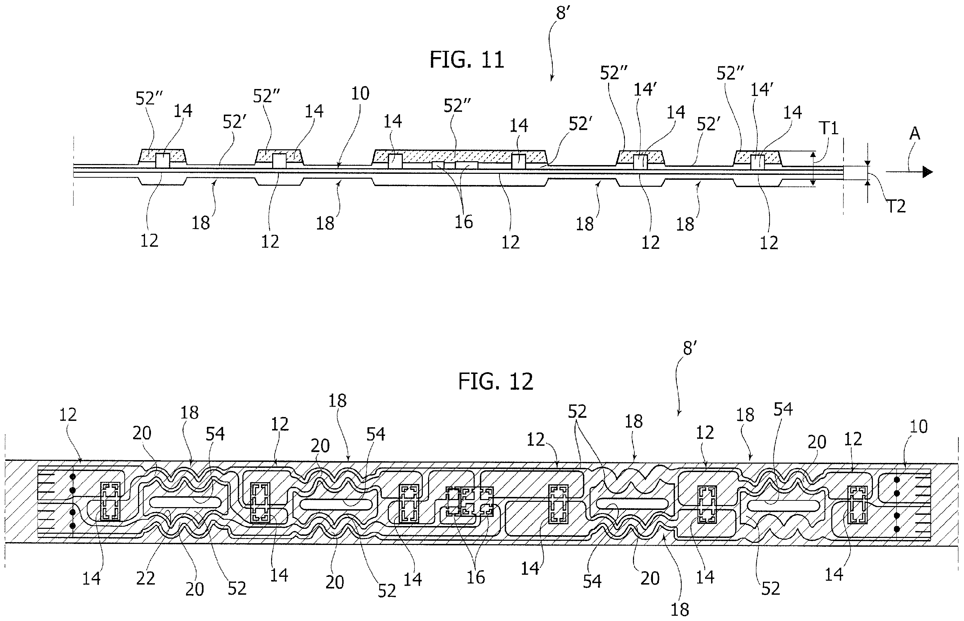

In one or more embodiments, in a second stage, a second liquid cross-linkable material 52" may be dispensed in the liquid state onto the first cross-linkable polymeric material 52'. The second cross-linkable polymeric material 52" may be a transparent material, e.g. transparent silicone, and may cover the light emission ends 14' of the light radiation sources 14 which have not been coated by the first cross-linkable polymeric material 52' (Figure 10). As shown in Figure 11, after crosslinking a lighting device 8' may be obtained having an encapsulation layer 52', 52" of a bi-component crosslinked polymeric material, with an opaque material covering the flexible printed circuit 10, the electronic components 16 and part of the light radiation sources 14, and a transparent polymeric material 52' covering the light emission ends 14' of the light radiation sources 14.

With reference to figure 12, in one or more embodiments the encapsulated lighting device 8' has at least one through opening 54 across the encapsulation layer 52, at one or more of said deformation portions 18. In one or more embodiments, the through opening 54 is arranged between two conductive tracks 20 of the deformation portions 18. In this way, the parts of the deformation portions 18 which are mutually separated by the through openings 54 may be kept mechanically independent from each other, so that they may bend differently when the lighting device 10 is bent transversally. The obtained transverse bending capability of the lighting device 10 is therefore improved. The removal of the encapsulation layer for the formation of the through openings 54 may be obtained in various ways, such as e.g. via laser cutting or a cutting die.

One or more embodiments may have one or the following advantages:
- possibility of obtaining a high IP protection degree for lighting devices, without impairing the transverse bending capability;
- if required by the application, the possibility is given of dispensing a cross-linkable polymeric material in two stages, in order to obtain lighting devices having two polymeric materials with different optical properties, e.g. an opaque material in the internal part, for covering the flexible printed circuit and the electronic components, and a transparent material on the external part, in order not to jeopardize the light emission characteristics of the light radiation sources;
- in addition to the advantages deriving from encapsulation layers of low thicknesses, openings may be formed in the encapsulation layer at the deformation portions; in this way, the transverse bending capability of the lighting device may be significantly improved.

## Claims

1. A lighting device comprising:
- a flexible printed circuit (10) elongated in a longitudinal direction (A) and including a plurality of mounting portions (12) spaced apart along said longitudinal direction (A) and connected to each other by deformation portions (18), and
- a plurality of electrically powered light radiation sources (14) fixed to said mounting portions (12),
wherein an encapsulation layer (52, 52', 52'') of cross-linked polymeric material covers said flexible printed circuit (10) and said light radiation source (14), wherein said polymeric material is dispensed in liquid form and subsequently crosslinked and wherein said encapsulation layer (52, 52', 52'') has a first thickness (T1) at said mounting portions (12) and a second thickness (T2) smaller than said first thickness (T1) at said deformation portions (18),
wherein least one through opening (54) is formed through said encapsulation layer (52, 52', 52'') at one or more of said deformation portions (18) and wherein one or more of said deformation portions (18) of said flexible printed circuit (10) comprise at least two conductive tracks (20) spaced apart in a transverse direction (B) and wherein said at least one through opening (54) is located between said conductive tracks (20) .

2. A lighting device according to claim 1, wherein said encapsulation layer (52', 52'') comprises an opaque crosslinked polymeric material (52') that covers said flexible printed circuit (10) and part of said light radiation sources (14) and leaves exposed light emission ends (14') of said light radiation sources (14), and a transparent crosslinked polymeric material (52") covering said light emission ends (14').

3. A method for producing a lighting device, comprising:
- providing a flexible printed circuit (10) elongated in a longitudinal direction (A) and including a plurality of mounting portions (12) spaced apart along said longitudinal direction (A) and connected to one another by deformation portions (18), with a plurality of electrically powered light radiation sources (14) fixed to said mounting portions (12), and
- coating said flexible printed circuit (10) and said light radiation sources (14) with an encapsulation layer (52, 52', 52") of cross-linked polymeric material wherein said polymeric material is dispensed in liquid form and subsequently crosslinked, wherein said encapsulation layer (52, 52', 52'') has a first thickness (T1) at said light radiation sources (14) and a second thickness (T2) smaller than said first thickness (T1) at said deformation portions (18),
- forming at least one through opening (54) through said encapsulation layer (52, 52', 52'') at one or more of said deformation portions (18), wherein said at least one through opening (54) is formed between two conductive tracks (20) spaced apart in a transverse direction (B) of one or more of said deformation portions (18).

4. A method according to claim 3, comprising:
- arranging said flexible printed circuit (10) with said light radiation source (14) attached thereto in a channel-shaped profile (40) of a profiled mold (26),
- inserting in said channel-shaped profile (40) filling formations (46) located at said deformation portions (18),
- delivering in said channel-shaped profile (40) liquid cross-linkable polymeric material (52, 52', 52'') and coating with said liquid cross-linkable polymeric material (52, 52', 52 '') said flexible printed circuit board (10) and said light radiation sources (14), with a thickness of said liquid cross-linkable polymeric material (52, 52', 52'') smaller at said filling formations (46), and
- crosslinking said liquid cross-linkable polymeric material (52, 52', 52'') in said channel-shaped profile (40).

5. A method according to claim 4, comprising:
- delivering in said channel-shaped profile (40) an opaque cross-linkable polymeric material (52') that covers said flexible printed circuit board (10) and part of said light radiation sources (14) leaving exposed light emitting ends (14') of said light radiation sources (14), and
- delivering in said channel-shaped profile (40) a cross-linkable transparent polymeric material (52'') covering said light emitting ends (14'), and
- crosslinking said opaque cross-linkable polymeric material (52') and said transparent cross-linkable polymeric material (52'') in said channel-shaped profile (40).

## Patentansprüche

1. Beleuchtungsvorrichtung, umfassend:
- eine flexible gedruckte Schaltung (10), die in einer Längsrichtung (A) langgestreckt ist und eine Vielzahl von Montageabschnitten (12) beinhaltet, die entlang der Längsrichtung (A) beabstandet und durch Verformungsabschnitte (18) miteinander verbunden sind, und
- eine Vielzahl von elektrisch betriebenen Lichtstrahlungsquellen (14), die an den Montageabschnitten (12) befestigt sind, wobei eine Verkapselungsschicht (52, 52', 52") aus vernetztem Polymermaterial die flexible gedruckte Schaltung (10) und die Lichtstrahlungsquelle (14) bedeckt, wobei das Polymermaterial in flüssiger Form abgegeben und anschließend vernetzt wird und wobei die Verkapselungsschicht (52, 52', 52") eine erste Dicke (T1) an den Montageabschnitten (12) und eine zweite Dicke (T2), die kleiner als die erste Dicke (T1) ist, an den Verformungsabschnitten (18) aufweist,
wobei mindestens eine Durchgangsöffnung (54) durch die Verkapselungsschicht (52, 52', 52") an einem oder mehreren der Verformungsabschnitte (18) gebildet ist und wobei einer oder mehrere der Verformungsabschnitte (18) der flexiblen gedruckten Schaltung (10) mindestens zwei Leiterbahnen (20) umfassen, die in einer Querrichtung (B) beabstandet sind, und wobei sich die mindestens eine Durchgangsöffnung (54) zwischen den Leiterbahnen (20) befindet.

2. Beleuchtungsvorrichtung nach Anspruch 1, wobei die Verkapselungsschicht (52', 52") ein opakes vernetztes Polymermaterial (52'), das die flexible gedruckte Schaltung (10) und einen Teil der Lichtstrahlungsquellen (14) bedeckt und freiliegende Lichtemissionsenden (14') der Lichtstrahlungsquellen (14) hinterlässt, und ein transparentes vernetztes Polymermaterial (52"), das die Lichtemissionsenden (14') bedeckt, umfasst.

3. Verfahren zur Herstellung einer Beleuchtungsvorrichtung, umfassend:
- Bereitstellen einer flexiblen gedruckten Schaltung (10), die in einer Längsrichtung (A) langgestreckt ist und eine Vielzahl von Montageabschnitten (12) beinhaltet, die entlang der Längsrichtung (A) beabstandet und durch Verformungsabschnitte (18) miteinander verbunden sind, mit einer Vielzahl von elektrisch betriebenen Lichtstrahlungsquellen (14), die an den Montageabschnitten (12) befestigt sind, und
- Beschichten der flexiblen gedruckten Schaltung (10) und der Lichtstrahlungsquellen (14) mit einer Verkapselungsschicht (52, 52', 52") aus vernetztem Polymermaterial, wobei das Polymermaterial in flüssiger Form abgegeben und anschließend vernetzt wird, wobei die Verkapselungsschicht (52, 52', 52") eine erste Dicke (T1) an den Lichtstrahlungsquellen (14) und eine zweite Dicke (T2), die kleiner als die erste Dicke (T1) ist, an den Verformungsabschnitten (18) aufweist,
- Bilden mindestens einer Durchgangsöffnung (54) durch die Verkapselungsschicht (52, 52', 52") an einem oder mehreren der Verformungsabschnitte (18), wobei die mindestens eine Durchgangsöffnung (54) zwischen zwei Leiterbahnen (20) gebildet ist, die in einer Querrichtung (B) von einem oder mehreren der Verformungsabschnitte (18) beabstandet sind.

4. Verfahren nach Anspruch 3, umfassend:
- Anordnen der flexiblen gedruckten Schaltung (10) mit der daran befestigten Lichtstrahlungsquelle (14) in einem kanalförmigen Profil (40) einer profilierten Form (26),
- Einsetzen von Füllformationen (46), die sich an den Verformungsabschnitten (18) befinden, in das kanalförmige Profil (40),
- Zuführen von flüssigem vernetzbarem Polymermaterial (52, 52', 52") in das kanalförmige Profil (40) und Beschichten der flexiblen gedruckten Schaltung (10) und der Lichtstrahlungsquellen (14) mit dem flüssigen vernetzbaren Polymermaterial (52, 52', 52"), wobei eine Dicke des flüssigen vernetzbaren Polymermaterials (52, 52', 52") an den Füllformationen (46) kleiner ist, und
- Vernetzen des flüssigen vernetzbaren Polymermaterials (52, 52', 52") in dem kanalförmigen Profil (40).

5. Verfahren nach Anspruch 4, umfassend:
- Zuführen eines opaken vernetzbaren Polymermaterials (52'), das die flexible gedruckte Schaltung (10) und einen Teil der Lichtstrahlungsquellen (14) bedeckt und freiliegende Lichtemissionsenden (14') der Lichtstrahlungsquellen (14) hinterlässt, in das kanalförmige Profil (40), und
- Zuführen eines vernetzbaren transparenten Polymermaterials (52"), das die Lichtemissionsenden (14') bedeckt, in das kanalförmige Profil (40), und
- Vernetzen des opaken vernetzbaren Polymermaterials (52') und des transparenten vernetzbaren Polymermaterials (52") in dem kanalförmigen Profil (40).

## Revendications

1. Un dispositif lumineux comprenant :
- un circuit imprimé flexible (10) allongé dans une direction longitudinale (A) et comprenant une pluralité de parties de montage (12) espacées les unes des autres le long de ladite direction longitudinale (A) et reliées les unes aux autres par des parties déformables (18), et
- une pluralité de sources de rayonnement lumineux alimentées électriquement (14) fixées auxdites parties de montage (12),
dans lequel une couche d'encapsulation (52, 52', 52") d'un matériau polymère réticulé recouvre ledit circuit imprimé flexible (10) et ladite source de rayonnement lumineux (14), dans lequel ledit matériau polymère est délivré sous forme liquide et ensuite réticulé, et dans lequel ladite couche d'encapsulation (52, 52', 52") a au niveau desdites parties de montage (12) une première épaisseur (T1), et au niveau desdites parties déformables (18) une seconde épaisseur (T2) inférieure à ladite première épaisseur (T1),
dans lequel au moins une ouverture traversante (54) est formée au travers de ladite couche d'encapsulation (52, 52', 52") au niveau d'une ou plusieurs desdites parties déformables (18), dans lequel une ou plusieurs desdites parties déformables (18) dudit circuit imprimé flexible (10) comprennent au moins deux pistes conductrices (20) espacées l'une de l'autre dans une direction transversale (B), et dans lequel ladite au moins une ouverture traversante (54) est située entre lesdites pistes conductrices (20).

2. Un dispositif d'éclairage selon la revendication 1, dans lequel ladite couche d'encapsulation (52', 52") comprend un matériau polymère réticulé opaque (52') qui recouvre ledit circuit imprimé flexible (10) et une partie desdites sources de rayonnement lumineux (14) et laisse exposées des extrémités d'émission lumineuse (14') desdites sources de rayonnement lumineux (14), et un matériau polymère réticulé transparent (52") recouvrant lesdites extrémités d'émission lumineuse (14').

3. Un procédé de production d'un dispositif d'éclairage, comprenant :
- l'obtention d'un circuit imprimé flexible (10) allongé dans une direction longitudinale (A) et comprenant une pluralité de parties de montage (12) espacées les unes des autres le long de ladite direction longitudinale (A) et reliées les unes aux autres par des parties déformables (18), avec une pluralité de sources de rayonnement lumineux alimentées électriquement (14) fixées auxdites portions de montage (12),
- le revêtement dudit circuit imprimé flexible (10) et desdites sources de rayonnement lumineux (14) par une couche d'encapsulation (52, 52', 52") de matériau polymère réticulé, ledit matériau polymère étant délivré sous forme liquide et ensuite réticulé, ladite couche d'encapsulation (52, 52', 52") ayant au niveau desdites sources de rayonnement lumineux (14) une première épaisseur (T1), et au niveau desdites parties déformables (18) une seconde épaisseur (T2) inférieure à ladite première épaisseur (T1), et
- la formation d'au moins une ouverture traversante (54) au travers de ladite couche d'encapsulation (52, 52', 52") au niveau d'une ou plusieurs desdites parties déformables (18), ladite au moins une ouverture traversante (54) étant formée entre deux pistes conductrices (20) espacées l'une de l'autre dans une direction transversale (B) d'une ou plusieurs desdites parties déformables (18).

4. Un procédé selon la revendication 3, comprenant :
- la mise en place dudit circuit imprimé flexible (10) avec ladite source de rayonnement lumineux (14) fixée dessus dans un profil en forme de gouttière (40) d'un moule profilé (26),
- l'insertion dans ledit profil en forme de gouttière (40) de formations de remplissage (46) situées au niveau desdites parties déformables (18),
- la délivrance dans ledit profil en forme de gouttière (40) d'un matériau polymère réticulable liquide (52, 52', 52") et le revêtement par ledit matériau polymère réticulable liquide (52, 52', 52") de ladite carte de circuit imprimé flexible (10) et desdites sources de rayonnement lumineux (14), avec une épaisseur dudit matériau polymère réticulable liquide (52, 52', 52") qui est inférieure au niveau desdites formations de remplissage (46), et
- la réticulation dudit matériau polymère réticulable liquide (52, 52', 52") dans ledit profil en forme de gouttière (40).

5. Un procédé selon la revendication 4, comprenant :
- la délivrance dans ledit profil en forme de gouttière (40) d'un matériau polymère réticulable opaque (52') qui recouvre ladite carte de circuit imprimé flexible (10) et une partie desdites sources de rayonnement lumineux (14) en laissant exposées des extrémités d'émission de lumière (14') desdites sources de rayonnement lumineux (14),
- la délivrance dans ledit profil en forme de gouttière (40) d'un matériau polymère transparent réticulable (52") recouvrant lesdites extrémités d'émission de lumière (14'), et
- la réticulation dudit matériau polymère réticulable opaque (52') et dudit matériau polymère réticulable transparent (52") dans ledit profil en forme de gouttière (40).
